(19)

Europäisches Patentamt
European Patent Office
Office européen des brevets

(11) **EP 2 599 761 A1**

(12) # EUROPEAN PATENT APPLICATION
published in accordance with Art. 153(4) EPC

(43) Date of publication:
**05.06.2013 Bulletin 2013/23**

(21) Application number: **11812627.5**

(22) Date of filing: **29.07.2011**

(51) Int Cl.:
*C04B 35/468* (2006.01)     *H01B 3/12* (2006.01)
*H01G 4/12* (2006.01)

(86) International application number:
**PCT/JP2011/067492**

(87) International publication number:
**WO 2012/015038 (02.02.2012 Gazette 2012/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.07.2010 JP 2010170749**

(71) Applicant: **Kyocera Corporation
Kyoto-shi
Kyoto 612-8501 (JP)**

(72) Inventors:
• **HIRAHARA,Seiichirou
Fushimi-ku, Kyoto-shi
Kyoto 612-8501 (JP)**

• **TODA,Hajime
Fushimi-ku, Kyoto-shi
Kyoto 612-8501 (JP)**
• **SUE,Toshiyuki
Fushimi-ku, Kyoto-shi
Kyoto 612-8501 (JP)**
• **MORI,Yutaka
Fushimi-ku, Kyoto-shi
Kyoto 612-8501 (JP)**

(74) Representative: **Beetz & Partner
Patentanwälte
Steinsdorfstrasse 10
80538 München (DE)**

(54) **DIELECTRIC CERAMIC AND DIELECTRIC FILTER INCLUDING SAME**

(57)     Provided are a dielectric ceramic having a high relative permittivity $\varepsilon r$, a high Qf value and a stable resonant-frequency temperature coefficient $\tau f$ close to 0 ppm/°C as well as a dielectric filter utilizing the dielectric ceramic. A dielectric ceramic includes a main crystal phase containing Ba, Nd and Ti; and a remainder, part of Ti contained in the main crystal phase being substituted with Al, a content of the Al contained in the main crystal phase to a total content of Al in the main crystal phase and the remainder being greater than or equal to 10% on $Al_2O_3$ basis. Accordingly, provided is a dielectric ceramic having a high relative permittivity $\varepsilon r$, a high Qf value and a stable resonant-frequency temperature coefficient $\tau f$ close to 0 ppm/°C. Also provided is a dielectric filter which is provided with the dielectric ceramic and in which a desired relative permittivity can be obtained with stability and a high Qf value can be obtained, and excellent performance capability can be maintained for a long period of time with stability in a place where wide temperature variations are encountered.

*FIG. 1*

EP 2 599 761 A1

**Description**

Technical Field

The present invention relates to a dielectric ceramic suitable to constitute a resonator and a filter, especially a dielectric filter for mobile-communication base stations, that are used in a high-frequency range including a microwave band and a millimeter-wave band.

Background Art

In keeping with the recent rapid advancement of technologies in the mobile-communication marketplace such as the cellular-phone and personal-computer marketplace, increasingly stringent requirements have been imposed on the characteristics of constituent components and materials. In general, dielectric ceramics for use in base stations for communication equipment, etc., while being required to exhibit high permittivity as a matter of course, need to satisfy various requirements such as the smallness of dielectric loss and a temperature coefficient of adequate level. Nowadays, as the trend in usable frequency is shifting toward even higher frequency zone in accompaniment with an increase in the variety of available features, a dielectric characteristic adapted particularly to a high-frequency region (800 MHz to 2 GHz) has come to be increasingly demanded.

For example, in Patent Literature 1, there is proposed a microwave dielectric porcelain composition material prepared by adding $Al_2O_3$ in an amount of less than or equal to 2.0 parts by weight to 100 parts by weight of a composite compound made of BaO, $TiO_2$ and $Nd_2O_3$ in which, given that it is expressed in general-formula form as: $XBaO + YTiO_2 + ZNd_2O_3$, the values of X, Y and Z fall within the range of $8.5 \leq X \leq 19.0$, the range of $67.0 \leq Y \leq 71.0$, and the range of $14.0 \leq Z \leq 24.5$ (mol%), respectively, and also the condition of X + Y + Z =1 is fulfilled.

Citation List

Patent Literature

Patent Literature 1: Japanese Unexamined Patent Publication JP-A 1-227303 (1989)

Summary of Invention

Technical Problem

However, in the $BaO$-$Nd_2O_3$-$TiO_2$-based dielectric ceramic as disclosed in Patent Literature 1, although it is possible to bring the temperature characteristic of resonant frequency $\tau f$ close to the vicinity of 0 ppm/°C while maintaining a proper relative permittivity $\varepsilon r$ by virtue of the addition of $Al_2O_3$, Qf-value improvement cannot be achieved.

An object of the invention is to provide a dielectric ceramic having a high Qf value and a stable resonant-frequency temperature coefficient $\tau f$ close to 0 ppm/°C, while maintaining a high relative permittivity $\varepsilon r$, as well as to provide a dielectric filter utilizing the dielectric ceramic.

Solution to Problem

A dielectric ceramic pursuant to the invention includes: a main crystal phase containing Ba, Nd and Ti; and a remainder, part of Ti contained in the main crystal phase being substituted with Al, a content of the Al contained in the main crystal phase to a total content of Al in the main crystal phase and the remainder being greater than or equal to 10% on $Al_2O_3$ basis.

Moreover, a dielectric filter pursuant to the invention includes: the dielectric ceramic as above described; an input terminal electromagnetically coupled to the dielectric ceramic, to the input terminal an external electric signal being inputted; and an output terminal electromagnetically coupled to the dielectric ceramic, the output terminal selectively outputting an electric signal corresponding to a resonant frequency of the dielectric ceramic.

Advantageous Effects of Invention

According to the invention, the dielectric ceramic includes the main crystal phase containing Ba, Nd and Ti and the remainder, part of Ti contained in the main crystal phase being substituted with Al, a content of the Al contained in the main crystal phase to a total content of Al in the main crystal phase and the remainder being greater than or equal to 10% on $Al_2O_3$ basis. Since the ions of elements constituting the main crystal phase are arranged symmetrically in an orderly manner, it is possible to attain a high relative permittivity and a high Qf value, as well as to bring the dependence of the resonant frequency of the dielectric ceramic on temperature into a condition of stability.

Moreover, according to the invention, in the dielectric filter, a desired relative permittivity can be obtained with stability and a high Qf value can be obtained, and therefore excellent performance capability can be maintained for a long period of time with stability in a place where wide temperature variations are encountered.

Brief Description of Drawings

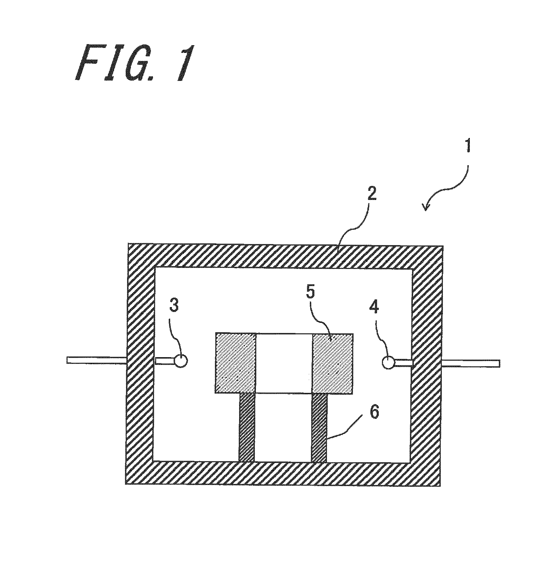

Fig. 1 is a schematic diagram showing a cross section of a dielectric filter according to the present embodiment.

Description of Embodiments

Hereinafter, exemplificative embodiments of a dielectric ceramic and a dielectric filter which utilizes the dielectric ceramic pursuant to the invention will be described.

The dielectric ceramic of the present embodiment includes a main crystal phase containing Ba, Nd and Ti and a remainder, part of Ti contained in the main crystal phase being substituted with Al, a content of the Al contained in the main crystal phase to a total content of Al in the main crystal phase and the remainder being greater than or equal to 10% on $Al_2O_3$ basis. Thus, in the dielectric ceramic, so long as part of Ti contained in the main crystal phase is substituted with Al in conformity with the above-described content range, as a general rule, a high relative permittivity $\varepsilon$r can be obtained with stability, a quality factor Qf value (the product of Q value and resonant frequency f) is increased, and the absolute value of a resonant-frequency temperature coefficient $\tau$f is decreased. This is presumably because, in the dielectric ceramic, its main crystal phase is a crystal phase of tungsten-bronze type structure, and the substitution of Al for Ti contained in the main crystal phase allows a lessening of strain in the crystal phase of the tungsten-bronze type crystalline structure. Moreover, it is more preferable that the content of Al contained in the main crystal phase falls in the range of 50% or more and 96% or less with respect to the total content of Al in the main crystal phase and the remainder. Although the part of the dielectric ceramic other than the main crystal phase, namely the remainder, should preferably have the form of a crystal phase, the remainder may include a glass phase in addition to a crystal phase or may consist solely of a glass phase. Moreover, the main crystal phase refers to, among crystal phases contained in the dielectric ceramic that have been identified by means of X-ray diffractometry or TEM-based electron diffractoemtry with reference to JCPDS cards for crystal-phase identification, a crystal phase having the largest volume proportion, and the remainder refers to the constituent elements of the dielectric ceramic other than the main crystal phase.

In this embodiment, the main crystal phase of the dielectric ceramic has the form of solid solution, and, in the monitoring of the ceramic surface and internal section of the dielectric ceramic for peak analysis of the elements constituting the main crystal phase by means of EPMA or TEM-based EDS (Energy Dispersive Spectroscopy) analysis or otherwise, if peaks in Ba, Nd, Ti and Al are observed, it can be judged that the main crystal phase is composed of the solid solutions of these elements, and also the amounts of the elements contained in the main crystal phase can be determined based on the peak values.

Moreover, the contents of Ba, Nd, Ti and Al in the dielectric ceramic can be determined by crushing part of the dielectric ceramic, dissolving the resultant powder in a solution such as a hydrochloric acid solution, and measuring the contents of Ba, Nd, Ti and Al in the solution on oxide basis with use of ICP emission spectrophotometer (Model ICPS-8100 manufactured by Shimadzu Corporation). Note that an error of the equipment for measurement is n $\pm$ $\sqrt{n}$, wherein n represents an analysis value.

It is preferable that the dielectric ceramic of this embodiment has a main crystal phase whose constitution is expressed as $aBaO \cdot bNd_2O_3 \cdot c(xTiO_2 + 1/2 \cdot (1-x)Al_2O_3)$, wherein a, b, c and x satisfy the following formulae (1) through (5):

$$13.50 \leq a \leq 16.10 \qquad (1)$$

$$17.60 \leq b \leq 19.40 \qquad (2)$$

$$65.30 \leq c \leq 67.80 \qquad (3)$$

$$0 < x < 1 \qquad (4)$$

$$a + b + c = 100 \qquad (5)$$

In the dielectric ceramic of this embodiment, where a, b, c and x satisfy the formulae (1) through (5), the main crystal phase is likely to be a crystal phase of tungsten-bronze type structure, and, as a general rule, a relative permittivity $\varepsilon r$ of greater than or equal to 60.0 can be obtained with stability, the quality factor Qf value (the product of Q value and resonant frequency f) is increased, and the absolute value of the resonant-frequency temperature coefficient $\tau f$ is decreased. Moreover, since the values of mole ratio a, b, c and x fulfill the following conditions of range: $14.13 \leq a \leq 15.60$; $18.16 \leq b \leq 19.23$; $65.38 \leq c \leq 67.39$; $0 < x < 1$; and $a + b + c = 100$, it follows that the main crystal phase is likely to be formed of solid solutions, and, as a general rule, an even higher relative permittivity $\varepsilon r$ can be obtained more stably, the quality factor Qf value is further increased, and the absolute value of the resonant-frequency temperature coefficient $\tau f$ is further decreased.

Moreover, in the dielectric ceramic of this embodiment, it is preferable that x satisfies the following formula (6):

$$0.830 \leq x \leq 0.940 \qquad (6)$$

In the dielectric ceramic of this embodiment, so long as x satisfies the formula (6), as a general rule, a relative permittivity $\varepsilon r$ of greater than or equal to 60.0 can be obtained more stably, the quality factor Qf value is further increased, and the absolute value of the resonant-frequency temperature coefficient $\tau f$ is further decreased.

Further, in the dielectric ceramic of this embodiment, it is preferable that a, b, c and x satisfy the following formula (7):

$$0.612 \leq cx/(a + b + cx) \leq 0.661 \qquad (7)$$

In the dielectric ceramic of this embodiment, so long as the value of cx/(a + b + cx) falls in the range of 0.612 or more and 0.661 or less, as a general rule, the relative permittivity $\varepsilon r$ and the quality factor Qf value are further increased, and the absolute value of the resonant-frequency temperature coefficient $\tau f$ is further decreased.

In addition, in the dielectric ceramic of this embodiment, it is preferable that the part other than the main crystal phase, namely the remainder, contains Ba-Al-Ti-based oxide, $Al_2O_3$, $Nd_2O_3$, or a mixture thereof.

In the dielectric ceramic of this embodiment, so long as the remainder has the form of a crystal phase containing Ba-Al-Ti-based oxide, $Al_2O_3$, $Nd_2O_3$, or a mixture thereof, it is possible to suppress deterioration in dielectric characteristics, maintain a high relative permittivity $\varepsilon r$ and a high quality factor Qf value, and suppress an increase in the absolute value of the resonant-frequency temperature coefficient $\tau f$ of the dielectric ceramic. Note that the Ba-Al-Ti-based oxide should preferably be of a type which causes no significant decline in the relative permittivity $\varepsilon r$ and the Qf value of the dielectric ceramic, or specifically it should preferably be of a type which has a relative permittivity $\varepsilon r$ of greater than or equal to 30 and a quality factor Qf value of greater than or equal to 10000 GHz. In particular, $Ba_{1.23}Al_{2.46}Ti_{5.54}O_{16}$ is desirable because of its advantage of maintaining superior dielectric characteristics. It is advisable that the proportion of the sum of the volumes of Ba-Al-Ti-based oxide, $Al_2O_3$, $Nd_2O_3$, or a mixture thereof contained in the remainder to the total volume of the remainder is greater than or equal to 90%.

Moreover, in the dielectric ceramic of this embodiment, it is preferable that a proportion by volume of the remainder to a total of the main crystal phase and the remainder is less than or equal to 10% by volume but excludes 0.

In the dielectric ceramic of this embodiment, so long as the proportion by volume of the crystal phase other than the main crystal phase of the dielectric ceramic to the total of the dielectric ceramic is less than or equal to 10% by volume, as a general rule, the relative permittivity $\varepsilon r$ and the quality factor Qf value can be maintained particularly high, and the absolute value of the temperature coefficient $\tau f$ can be maintained particularly small. It is more preferable that the proportion of the crystal phase other than the main crystal phase is less than or equal to 5% by volume.

For example, the volume proportion between the main crystal phase and the remainder can be determined by taking photographs or images of several areas at the ceramic surface and internal section of the dielectric ceramic by a metallurgical microscope, SEM, BEM, EPMA, or the like set at a proper magnification for observation of a range of 100 $\mu$m x 100 $\mu$m, analyzing the photographs or images by an image analyzer for calculation of the crystal-phase proportions of the several areas, and deriving the mean value of the calculated data. Moreover, it is advisable to use, for example, LUZEX-FS manufactured by Nireco Corporation as the image analyzer.

Moreover, in the dielectric ceramic of this embodiment, the total content of elements other than Ba, Nd, Ti and Al but excluding O in the remainder is less than or equal to 1.0% by mass on oxide basis.

In the dielectric ceramic of this embodiment, so long as the total content of the elements other than Ba, Nd, Ti and Al but excluding O in the main crystal phase and the remainder is less than or equal to 1.0% by mass on oxide basis, as a general rule, the sinterability of the dielectric ceramic can be enhanced, and thus the dielectric ceramic is further densified and possesses superior mechanical characteristics. Examples of the elements other than Ba, Nd, Ti and Al include Na, K, Ca, Mg, Sr, Fe, Si, La, Ce, Pr and Zr. Moreover, Na, K, Ca, Mg, Sr, Fe, Si, La, Ce, Pr and Zr have a disposition to form a low-melting-point compound at the grain boundaries of the dielectric ceramic and effects liquid-phase formation in a range of temperatures lower than the sintering temperature of the dielectric ceramic, thereby facilitating sintering process. Further, where the total content of at least one of Na, K, Ca, Mg, Sr, Fe, Si, La, Ce, Pr and Zr is less than or equal to 1.0% by mass on oxide basis, it never occurs that the content of a low-melting-point compound becomes excessive, wherefore a decline in the relative permittivity and the quality factor Qf value, as well as an increase in the dependence of resonant frequency on temperature, can be suppressed. It is more preferable that the content of the elements other than Ba, Nd, Ti and Al but excluding O in the main crystal phase and the remainder is less than or equal to 0.4% by mass on oxide basis.

Moreover, the elements other than Ba, Nd, Ti and Al but excluding O should preferably be contained in the remainder, because, in this case, a decline in the relative permittivity and the quality factor Qf value and an increase in the dependence of resonant frequency on temperature can be suppressed more successfully.

It is noted that the content of each of the elements: Na, K, Ca, Mg, Sr, Fe, Si, La, Ce, Pr and Zr can be determined, as is the case with Ba, Nd, Ti and Al, by crushing part of the dielectric ceramic, dissolving the resultant powder in a solution such as a hydrochloric acid solution, and measuring the content of each of Na, K, Ca, Mg, Sr, Fe, Si, La, Ce, Pr and Zr in the solution with use of ICP emission spectrophotometer (Model ICPS-8100 manufactured by Shimadzu Corporation) to derive a total content on oxide basis. Note that an error of the equipment for measurement is $n \pm \sqrt{n}$, wherein n represents an analysis value.

Moreover, in the dielectric ceramic of this embodiment, it is preferable that the relative permittivity $\varepsilon r$ is greater than or equal to 60 ($\varepsilon r \geq 60$), the Qf value is greater than or equal to 13000 GHz (Qf $\geq$ 13000 GHz), and the resonant-frequency temperature characteristic $\tau f$ in 25°C to 85°C falls in the range of - 10 ppm/°C or more and 20 ppm/°C or less.

The dielectric ceramic of this embodiment, so long as it affords the above-described characteristics, is, as a general rule, conducive to a downsizing of a dielectric filter because of its having a high relative permittivity, incurs relatively small electrical loss because of its having a high quality factor Qf value, and is able to withstand use in an environment where wide temperature variations are encountered because of its having a small resonant-frequency temperature characteristic $\tau f$ in 25°C to 85°C, or equivalently under a normal use environment.

Moreover, in the dielectric ceramic of this embodiment, it is preferable that the surface and the interior thereof has an average void fraction of less than or equal to 5%.

In the dielectric ceramic of this embodiment, where the average void fraction is less than or equal to 5%, a decline in the relative permittivity $\varepsilon r$ and the quality factor Qf value is less likely to occur, and this makes it possible to suppress deterioration in dielectric characteristics and thereby afford stability to the dielectric characteristics. More desirably, by adjusting the void fraction to be less than or equal to 3%, the dielectric characteristics can be readily stabilized. Note that, in the case of forming a dielectric filter with use of a ceramic body including the dielectric ceramic of this embodiment, so long as the average void fraction of the dielectric ceramic is less than or equal to 5%, too large a drop in the density of the ceramic body will not take place, wherefore deterioration in mechanical characteristics can be suppressed. Consequently, the ceramic body can be made less prone to chipping, cracking, and breakage when it is subjected to vibration and impact at the time of handling, falling, attachment into a resonator, installation on each base station, and other occasions.

For example, the above-described void fraction can be determined by taking photographs or images of several areas at the ceramic surface and internal section of the dielectric ceramic by a metallurgical microscope, SEM, or the like set at a proper magnification for observation of a range of 100 $\mu$m x 100 $\mu$m, analyzing the photographs or images by an image analyzer for calculation of, as a void fraction, the proportion of voids per unit area in each of the several areas, and deriving the mean value of the calculated data. It is advisable to use, for example, LUZEX-FS manufactured by Nireco Corporation as the image analyzer.

Next, a method for manufacturing the dielectric ceramic of this embodiment will be described. For example, the dielectric ceramic can be produced by following process steps (a) through (g) as set forth hereunder.

(a) As raw materials, there are prepared powders of high-purity barium carbonate ($BaCO_3$), neodymium oxide ($Nd_2CO_3$), titanium oxide ($TiO_2$) and aluminum oxide ($Al_2O_3$). Then, these powders are weighed so that each of $BaCO_3$, $Nd_2CO_3$, $TiO_2$ and $Al_2O_3$ makes up a desired proportion. Next, pure water is added to the thusly weighed powders, and the resultant product is pulverized for 1 to 50 hours until the average particle size of the mixed raw materials becomes 2.0 $\mu$m or below by a ball mill employing a zirconia ball or the like, thereby producing a mixture.

(b) The mixture is, after being dried, calcined for 1 to 10 hours at 900 to 1300°C to obtain a calcined material. At this time, by making adjustment to the temperature or time for calcination, it is possible to control the volume proportion of the crystal phase of the remainder arbitrarily. For example, when the calcination temperature is low or the calcination time is short, the synthesis of the main crystal phase is retarded, with the consequence that, in the dielectric ceramic, the volume proportion of the crystal phase other than the main crystal phase tends to increase.
(c) The thus obtained calcined material is pulverized by a ball mill or the like until the average particle size becomes 0.5 to 3 $\mu$m, and the resultant mixture is put in a container, and subsequently the calcined material is sifted through a sieve with Number 80 mesh defined in the standard ASTM E 11-61 for sizing, thereby preparing calcined powder having particles that fall within the size range downwardly from 177 $\mu$m, for example. Note that MASSCOLLOIDER may be used instead of the ball mill for the pulverization of the calcined material.
(d) After the addition of pure water to the calcined powder prepared in the step (c), mixing is performed for 1 to 30 hours until the average particle size becomes 2.0 $\mu$m or below by a ball mill employing a zirconia ball or the like.
(e) After the addition of 3 to 10% by mass of a binder, for example, an organic binder such as paraffin wax, acrylic polymer, urethane polymer, polyvinyl alcohol (PVA), or polyethylene glycol (PEG) to the mixture, they are subjected to granulation or sizing granulation by spray-drying technique for example, and the resultant granules, particle-sized powder, or the like is molded into an arbitrary shape by means of mold pressing technique, cold isostatic pressing technique, extrusion molding technique, or otherwise, for example.
(f) The resultant molded body is fired while being held in an air atmosphere for 1 to 10 hours at 1350°C to 1550°C to form a fired body. More preferably, the firing is performed at 1400°C to 1500°C.
(g) On an as needed basis, the thus obtained fired body is subjected to heat treatment for 30 minutes to 100 hours in the presence of a gas containing oxygen in an amount of 5 to 30% by volume, at a temperature of 900°C to 1500°C, and at a pressure of 0.1 MPa to 300 MPa. More preferably, the heat treatment is carried out for 1 to 60 hours at a temperature of 1000°C to 1300°C and at a pressure of 1 atmosphere to 1000 atmosphere.

Next, an example of a dielectric filter utilizing the dielectric ceramic of this embodiment will be described below.
Fig. 1 is a schematic diagram showing an example of a cross section of a dielectric filter according to the present embodiment.
As shown in Fig. 1, a dielectric filter 1 of TE mode-type of this embodiment includes a metallic case 2, an input terminal 3, an output terminal 4, a ceramic body 5, and a placement base 6. The metallic case 2 is made of a lightweight metal such as aluminum, and the input terminal 3 and the output terminal 4 are disposed on the opposite sides, respectively, of the inner wall of the metallic case 2. Moreover, the ceramic body 5 is composed of the dielectric ceramic of this embodiment. The ceramic body 5 is placed between the input terminal 3 and the output terminal 4 so as to be electromagnetically coupled to the input terminal 3 and the output terminal 4. In such a dielectric filter 1, upon the inputting of an external electric signal to the input terminal 3, a magnetic field is developed in the input terminal 3 within the metallic case 2. With the magnetic energy, the ceramic body 5 produces resonance at a specific frequency, thereby developing a magnetic field. With this magnetic energy, a magnetic field is developed in the output terminal 4 to cause a flow of electric current, whereupon electric signal output is produced by the output terminal 4. In this way, the dielectric filter 1 can selectively output electric signals corresponding to the resonant frequency of the dielectric ceramic.
It is noted that the mode of the filter is not limited to the TE mode, and therefore a TM mode, a TEM mode, or a multiple mode may be adopted instead. Moreover, the structure of the dielectric filter 1 is not limited to the structure as above described, and therefore the input terminal 3 and the output terminal 4 may be attached directly to the ceramic body 5. Further, while the ceramic body 5 is a resonant medium having a predetermined shape and made of the dielectric ceramic of this embodiment, the ceramic body 5 may have any given shape, for example, a tubular shape, a rectangular prism shape, a hexahedron shape, a plate shape, a disc shape, a circular cylinder shape, or a polygonal column shape, so long as it takes on a three-dimensional shape capable of resonance. In addition, high-frequency signals to be inputted range in frequency of about 500 MHz to 500 GHz, and the range of about 2 GHz to 80 GHz is desirable in regard to resonant frequency.
The dielectric filter of this embodiment, being implemented as a filter having the dielectric ceramic of this embodiment which provides a high relative permittivity, a high Qf value and a temperature coefficient $\tau$f close to 0 ppm/°C, is able to serve as a dielectric filter having excellent performance capability.
Moreover, the dielectric ceramic of this embodiment may be applicable to, in addition to a variety of dielectric filter materials, dielectric substrates for MIC (Monolithic IC), dielectric waveguides, dielectric antennas, multi-layered ceramic capacitors and the like.

Example 1

Test samples of the BaO-Nd$_2$O$_3$-TiO$_2$-Al$_2$O$_3$-based material of this embodiment were formed in a manner such that they differ from one another in the values of a, b, c and x and the value of cx/(a + b + cx), and measurement was made of the relative permittivity εr, quality factor Qf value and resonant-frequency temperature coefficient τf in 25°C to 85°C of each sample. A detailed explanation of the methods for sample production and characteristics measurement will be given below.

As starting materials, $BaCO_3$, $Nd_2O_3$, $TiO_2$ and $Al_2O_3$ having a purity of greater than or equal to 99.5% by mass were prepared.

Next, these materials were each weighed so as to make up the proportion as shown in Table 1. Then, the mix of $BaCO_3$, $Nd_2O_3$, $TiO_2$ and $Al_2O_3$ was put in a ball mill, and pure water was added into the ball mill. After that, they were pulverized until the average particle size of the mixed raw materials falls within the range of 0.5 μm to 2.0 μm by a ball mill employing a zirconia ball, thereby producing a mixture.

The thusly obtained mixture was dried, and then calcined at 1100°C to form a calcined material, and the calcined material was sifted through a sieve with Number 80 mesh defined in the standard ASTM E 11-61 for sizing, thereby preparing calcined powder having particles that fell within the size range downwardly from 177 μm, for example. After the addition of pure water to the calcined powder, they were pulverized for 1 to 30 hours until the average particle size fell within the range of 0.5 μm to 2.0 μm by a ball mill employing a zirconia ball or the like, thereby producing slurries for Sample Nos. 1 through 45 as listed in Table 1, respectively.

Next, after the addition of 3 to 10% by mass of polyvinyl alcohol to each of the slurries, mixing was performed for a predetermined period of time, and the slurry product was subjected to spray-drying granulation process to form a secondary material. The secondary material was molded into a cylindrical body which is 20 mm in diameter and 15 mm in height by the mold pressing technique, thereby forming a molded body.

The thus obtained molded body was fired while being held in an air atmosphere for 2 hours at 1400°C to 1500°C, whereupon Sample Nos. 1 through 45 were produced. Note that each of the samples had its upper and lower surfaces and part of its side surfaces polished and was also subjected to ultrasonic cleaning in acetone following the completion of firing process.

Next, Sample Nos. 1 through 45 were evaluated in respect of dielectric characteristics. In the evaluation of dielectric characteristics, the relative permittivity εr and the Q value of each of Sample Nos. 1 through 45 were measured at a measurement frequency of 4 to 5 GHz in accordance with the cylindrical dielectric resonator method (defined by International standard IEC 61338-1-3 (1999)). Note that the Q value was measured in terms of quality factor Qf value which is represented by the product of Q value and measurement frequency f. Moreover, resonant frequencies in a temperature range of 25°C to 85°C were measured, and a resonant-frequency temperature coefficient τf in 25°C to 85°C was determined by calculation with reference to the resonant frequency at 25°C. Note that the sample was set in a metallic cavity connected with input and output terminals, and, after placing the metallic cavity in a constant-temperature bath, resonant frequencies as observed in intended temperature conditions were measured. Thus, the resonant-frequency temperature coefficient τf in 25°C to 85°C can be calculated using the following formula:

$$\tau f = (f_{85} - f_{25})/f_{25}/(85 - 25)$$

wherein $f_{85}$ represents the resonant frequency obtained by measurement at 85°C and $f_{25}$ represents the resonant frequency obtained by measurement at 25°C.

Moreover, in each of Sample Nos. 1 through 45 produced, the content of Al contained in the main crystal phase was determined by identifying the main crystal phase by means of TEM-based EDS analysis, measuring ATOM percentage of Al dissolved in a solid state in the main crystal phase, and converting the measured value into the value of $Al_2O_3$ (mol%). Further, the total content of Al in the main crystal phase and the remainder of each sample was determined by crushing part of the sample, dissolving the resultant powder in hydrochloric acid, measuring the content of Al in the solution with use of ICP emission spectrophotometer (Model ICPS-8100 manufactured by Shimadzu Corporation), and converting the measured value into the value of $Al_2O_3$ (mol%). On the basis of these derived values, the ratio of the content of Al contained in the main crystal phase of the sample to the total content of Al in the main crystal phase and the remainder was determined by calculation.

The result is shown in Table 1.

Table 1

| Sample No. | a [mol%] | b [mol%] | c [mol%] | x | cx/(a+b+cx) | Al content in main crystal phase [%] | Dielectric characteristics | | |
|---|---|---|---|---|---|---|---|---|---|
| | | | | | | | Relative permittivity $\varepsilon_r$ | Quality factor Qf | Temperature coefficient $\tau f$ in 25-85°C [PPm/°C] |
| 1 | 13.48 | 18.73 | 67.79 | 0.946 | 0.666 | 21.0 | 72.3 | 12700 | +16.4 |
| 2 | 13.51 | 18.80 | 67.69 | 0.946 | 0.665 | 52.4 | 72.5 | 13100 | +18.5 |
| 3 | 13.92 | 18.56 | 67.52 | 0.940 | 0.661 | 55.1 | 72.3 | 13100 | +7.8 |
| 4 | 14.75 | 18.69 | 66.56 | 0.880 | 0.637 | 78.4 | 67.5 | 15700 | -3.4 |
| 5 | 15.34 | 17.82 | 66.84 | 0.863 | 0.636 | 68.9 | 72.8 | 13600 | +7.3 |
| 6 | 15.60 | 18.26 | 66.15 | 0.880 | 0.632 | 77.1 | 67.3 | 15600 | +4.5 |
| 7 | 16.08 | 18.38 | 65.54 | 0.840 | 0.615 | 54.0 | 68.3 | 13200 | +6.5 |
| 8 | 16.12 | 18.38 | 65.50 | 0.841 | 0.615 | 38.3 | 68.5 | 12900 | +7.1 |
| 9 | 15.50 | 17.58 | 66.92 | 0.949 | 0.658 | 15.7 | 76.9 | 12900 | +20.5 |
| 10 | 15.46 | 17.62 | 66.92 | 0.967 | 0.662 | 53.4 | 75.4 | 13100 | +18.3 |
| 11 | 15.92 | 18.28 | 65.80 | 0.860 | 0.623 | 62.8 | 69.5 | 14100 | +7.5 |
| 12 | 14.91 | 18.42 | 66.67 | 0.900 | 0.643 | 65.4 | 67.9 | 15500 | +0.8 |
| 13 | 15.23 | 18.82 | 65.95 | 0.840 | 0.619 | 76.5 | 63.4 | 15900 | -5.6 |
| 14 | 14.13 | 19.09 | 66.78 | 0.860 | 0.634 | 75.4 | 68.2 | 14900 | -4.6 |
| 15 | 14.16 | 19.38 | 66.46 | 0.840 | 0.625 | 51.2 | 60.2 | 13800 | -6.5 |
| 16 | 14.12 | 19.42 | 66.46 | 0.840 | 0.625 | 44.0 | 59.5 | 13900 | -8.1 |
| 17 | 15.46 | 19.23 | 65.28 | 0.892 | 0.627 | 32.9 | 72.0 | 12900 | -5.8 |
| 18 | 15.45 | 19.23 | 65.32 | 0.891 | 0.627 | 50.5 | 70.0 | 13200 | -4.3 |
| 19 | 15.50 | 18.68 | 65.82 | 0.840 | 0.618 | 77.1 | 64.8 | 15400 | +1.5 |
| 20 | 15.28 | 18.42 | 66.30 | 0.880 | 0.634 | 78.9 | 67.5 | 15100 | +3.1 |
| 21 | 14.65 | 18.55 | 66.80 | 0.900 | 0.644 | 71.6 | 67.8 | 15200 | +0.3 |
| 22 | 14.02 | 18.69 | 67.29 | 0.920 | 0.654 | 70.2 | 70.0 | 13300 | +5.4 |
| 23 | 13.61 | 18.63 | 67.76 | 0.950 | 0.666 | 50.0 | 73.9 | 13100 | +9.6 |
| 24 | 13.51 | 18.67 | 67.82 | 0.950 | 0.667 | 10.0 | 74.5 | 12700 | +9.8 |
| 25 | 15.07 | 19.09 | 65.84 | 0.843 | 0.619 | 83.0 | 64.3 | 16100 | -7.2 |
| 26 | 15.07 | 19.09 | 65.84 | 0.840 | 0.618 | 75.8 | 64.6 | 15800 | -6.1 |
| 27 | 16.03 | 18.41 | 65.56 | 0.840 | 0.615 | 74.3 | 68.1 | 13500 | +6.2 |
| 28 | 15.71 | 18.39 | 65.91 | 0.860 | 0.624 | 74.8 | 66.2 | 14800 | +2.8 |
| 29 | 15.38 | 19.23 | 65.38 | 0.889 | 0.627 | 86.4 | 70.0 | 15000 | -4.5 |
| 30 | 15.07 | 18.16 | 66.77 | 0.940 | 0.654 | 79.4 | 70.2 | 15200 | +2.9 |
| 31 | 13.87 | 18.50 | 67.63 | 0.960 | 0.667 | 72.1 | 74.1 | 13500 | +7.2 |
| 32 | 14.09 | 18.30 | 67.61 | 0.962 | 0.668 | 60.9 | 74.0 | 13200 | +9.8 |
| 33 | 15.40 | 19.30 | 65.30 | 0.823 | 0.608 | 73.7 | 61.4 | 15800 | -9.7 |
| 34 | 15.82 | 18.68 | 65.50 | 0.830 | 0.612 | 73.9 | 66.5 | 14900 | +1.9 |

(continued)

| Sample No. | a [mol%] | b [mol%] | c [mol%] | x | cx/(a+b+cx) | Al content in main crystal phase [%] | Dielectric characteristics | | |
|---|---|---|---|---|---|---|---|---|---|
| | | | | | | | Relative permittivity $\varepsilon r$ | Quality factor Qf | Temperature coefficient $\tau f$ in 25-85°C [PPm/°C] |
| 35 | 15.02 | 18.68 | 66.30 | 0.840 | 0.623 | 90.8 | 67.5 | 15200 | -0.9 |
| 36 | 15.18 | 18.29 | 66.54 | 0.900 | 0.642 | 95.1 | 67.7 | 15300 | +5.3 |
| 37 | 14.81 | 18.29 | 66.90 | 0.920 | 0.650 | 88.3 | 69.5 | 15100 | +4.6 |
| 38 | 14.18 | 18.43 | 67.39 | 0.940 | 0.660 | 81.4 | 72.6 | 15500 | +5.6 |
| 39 | 14.13 | 18.08 | 67.79 | 0.950 | 0.667 | 75.0 | 74.5 | 14000 | +15.4 |
| 40 | 14.02 | 18.20 | 67.78 | 0.955 | 0.668 | 61.5 | 74.4 | 13500 | +10.2 |
| 41 | 11.02 | 20.05 | 68.93 | 0.970 | 0.683 | 3.5 | 65.2 | 6800 | +15.0 |
| 42 | 17.04 | 19.92 | 63.04 | 0.820 | 0.583 | 7.2 | 70.4 | 8700 | +68.7 |
| 43 | 16.30 | 15.50 | 68.20 | 0.980 | 0.678 | 1.3 | 79.7 | 8200 | +63.0 |
| 44 | 15.40 | 19.30 | 65.30 | 0.828 | 0.609 | 71.4 | 61.4 | 13100 | -9.9 |
| 45 | 15.07 | 19.09 | 65.84 | 0.938 | 0.644 | 79.6 | 70.2 | 15100 | +4.1 |

It has been found from Table 1 that there is a tendency that, in point of the quality factor Qf value and the temperature coefficient $\tau f$ value, Sample Nos. 1 through 40, 44 and 45, in which the content of Al contained in the main crystal phase is greater than or equal to 10% with respect to the total content of Al in the main crystal phase and the remainder, are characteristically superior to Sample Nos. 41 through 43 in which the content of Al contained in the main crystal phase is less than 10% with respect to the total content of Al in the main crystal phase and the remainder.

It has also been found that there is a tendency that, in point of the relative permittivity $\varepsilon r$, the quality factor Qf value, and the temperature coefficient $\tau f$ value, Sample Nos. 2 through 7, 10 through 15, 18 through 23, 25 through 40, 44 and 45, in which the content of Al contained in the main crystal phase is greater than or equal to 50% with respect to the total content of Al in the main crystal phase and the remainder, are characteristically superior to Sample Nos. 1, 8, 9, 16, 17 and 24 in which the content of Al contained in the main crystal phase is less than 50% with respect to the total content of Al in the main crystal phase and the remainder.

Moreover, it has been found from Table 1 that there is a tendency that Sample Nos. 2 through 7, 10 through 15, 18 through 23, 25 through 40, 44 and 45, in which the values of a, b and c fulfill the conditions: $13.50 \le a \le 16.10$; $17.60 \le b \le 19.40$; $65.30 \le c \le 67.80$; and a + b + c = 100 (the number of decimal places is rounded off), have a relative permittivity $\varepsilon r$ of greater than or equal to 60 ($\varepsilon r \ge 60$), a Qf value of greater than or equal to 13000 GHz (Qf $\ge$ 13000 GHz), and a temperature characteristic $\tau f$ falling in the range of -10 ppm/°C or more and 20 ppm/°C or less, and are therefore capable of affording excellent characteristics. It has also been found that there is a tendency that Sample Nos. 4, 6, 13, 14, 19 through 21, 25, 26, 29, 30, 35 through 38 and 45, in which the values of a, b and c fulfill the conditions: $14.13 \le a \le 15.60$; $18.16 \le b \le 19.23$; $65.38 \le c \le 67.79$; and a + b + c = 100 (the number of decimal places is rounded off), have a relative permittivity $\varepsilon r$ of greater than or equal to 63.4 ($\varepsilon r \ge 63.4$), a Qf value of greater than or equal to 14900 GHz (Qf $\ge$ 14900 GHz), and a temperature characteristic $\tau f$ falling in the range of -7.2 ppm/°C or more and 5.6 ppm/°C or less, and are therefore capable of affording more excellent characteristics.

Moreover, it has been found that there is a tendency that Sample Nos. 3 through 7, 11 through 15, 18 through 22, 25 through 30, 34 through 38 and 45, in which the values of a, b and c fulfill the conditions: $13.50 \le a \le 16.10$; $17.60 \le b \le 19.40$; $65.30 \le c \le 67.80$; and a + b + c = 100 (the number of decimal places is rounded off) and also the value of x falls in the range of 0.830 or more and 0.940 or less, are capable of affording excellent characteristics.

Further, it has been found that there is a tendency that the sample, in which the values of a, b and c fulfill the conditions: $13.50 \le a \le 16.10$; $17.60 \le b \le 19.40$; $65.30 \le c \le 67.80$; and a + b + c = 100 (the number of decimal places is rounded off) and also the value of cx/(a + b + cx) falls in the range of 0.612 or more and 0.661 or less, is capable of affording excellent characteristics.

Example 2

Next, tests to determine the influence of the part other than the main crystal phase, namely the remainder, on the dielectric characteristics were carried out.

Samples for use in the tests were made basically in the same manner as that adopted in Example 1, except that the materials were prepared so that each of a, b, c and x took on the same value as that in Sample No. 12 shown in Table 1 and the calcination temperature and calcination time were changed arbitrarily.

Measurement was made of the relative permittivity $\varepsilon r$, quality factor Qf value, resonant-frequency temperature coefficient $\tau f$ in 25°C to 85°C, and the content of Al contained in the main crystal phase of each of Sample Nos. 46 through 52 thus produced in accordance with the same measurement method as that adopted in Example 1. Moreover, in determining the volume proportion between the main crystal phase and the remainder, images were taken by EPMA set at a proper magnification for observation of a range of 100 $\mu$m x 100 $\mu$m in a given internal section of each sample, and the images were analyzed by an image analyzer to calculate the ratio in crystal phase between the main crystal phase and the remainder. At this time, measurement was performed on five areas of the given section, and the mean value of the measured data was derived, whereby the volume proportion was determined. Note that the constituent components of the main crystal phase and the remainder were identified by the TEM-based electron diffractometry. The result of identification of the remainder of each of Sample Nos. 46 through 52 by the TEM-based electron diffractometry showed that the remainder of each of Sample Nos. 47 through 52 had the form of a crystal phase represented by $Ba_{1.23}Al_{2.46}Ti_{5.54}O_{16}$ (indicated as BAT in Table 2), $Al_2O_3$, or $Nd_2O_3$, whereas the remainder of the sample numbered 46 was of $BaTi_4O_9$, $Nd_2$-$Ti_2O_7$ and $NdAlO_3$.

The result is shown in Table 2.

Table 2

| Sample No. | a (mol%) | b (mol%) | c (mol%) | x | Calcination temperature (°C) | Main crystal phase [vol.%] | Remainder | | | Total volume of remainder [vol.%] | Al content in main crystal phase [mol%] | Dielectric characteristics | | |
|---|---|---|---|---|---|---|---|---|---|---|---|---|---|---|
| | | | | | | | BAT [vol.%] | Al$_2$O$_3$ [vol.%] | Nd$_2$O$_3$ [vol.%] | | | Relative permittivity εr | Quality factor Qf (GHz) | Temperature coefficient τf in 25-85°C (ppm/°C) |
| 46 | 14.91 | 18.42 | 66.67 | 0.947 | 925 | 75.0 | - | - | - | 25.0 | 19.8 | 72.8 | 12500 | +15.9 |
| 47 | 14.91 | 18.42 | 66.67 | 0.947 | 950 | 90.0 | 5.0 | 2.0 | 3.0 | 10.0 | 20.1 | 70.4 | 15000 | +5.3 |
| 48 | 14.91 | 18.42 | 66.67 | 0.947 | 1000 | 94.3 | 3.0 | 1.7 | 1.0 | 5.7 | 38.6 | 69.2 | 15200 | +3.2 |
| 49 | 14.91 | 18.42 | 66.67 | 0.947 | 1100 | 96.5 | 2.4 | 0.7 | 0.4 | 3.5 | 65.4 | 67.9 | 15500 | +0.8 |
| 50 | 14.91 | 18.42 | 66.67 | 0.947 | 1150 | 97.5 | 1.5 | 1.0 | 0.0 | 2.5 | 65.9 | 67.2 | 15700 | -0.5 |
| 51 | 14.91 | 18.42 | 66.67 | 0.947 | 1200 | 98.5 | 0.8 | 0.7 | 0.0 | 1.5 | 77.4 | 66.8 | 15900 | -1.9 |
| 52 | 14.91 | 18.42 | 66.67 | 0.947 | 1250 | 99.0 | 0.5 | 0.5 | 0.0 | 1.0 | 84.3 | 65.1 | 16000 | -3.0 |

It has been found from Table 2 that there is a tendency that Sample Nos. 47 through 52, in which the part other than the main crystal phase, namely the remainder has the form of a crystal phase represented by $Ba_{1.23}Al_{2.46}Ti_{5.54}O_{16}$ which is Ba-Al-Ti-based oxide, $Al_2O_3$, or $Nd_2O_3$, are higher in the quality factor Qf value and the resonant-frequency temperature coefficient $\tau f$ than Sample No. 46 in which the remainder has no such a crystal phase. It has also been found that there is a tendency that, so long as the volume proportion of the part other than the main crystal phase, namely the remainder is less than or equal to 10% by volume, the relative permittivity $\varepsilon r$ is maintained high, the quality factor Qf value is increased, and the temperature coefficient $\tau f$ becomes even closer to 0 ppm/°C.

Example 3

Next, tests to determine the influence of the total content of elements other than Ba, Nd, Ti and Al but excluding O in the dielectric ceramic on the dielectric characteristics were carried out.

Samples for use in the tests were made basically in the same manner as that adopted in Example 1 under the condition that, in the process of pulverizing the calcined material, at least one of pre-prepared sodium carbonate ($NaCO_3$), potassium carbonate ($K_2CO_3$), calcium carbonate ($CaCO_3$), magnesium carbonate ($MgCO_3$), strontium carbonate ($SrCO_3$), iron oxide ($Fe_2CO_3$), silicon oxide ($SiO_2$), lanthanum oxide ($La_2CO_3$), cerium oxide ($CeO_2$), praseodymium oxide ($Pr_6O_{11}$), and zirconium oxide ($ZrO_2$) was added in an amount as shown in Table 3. Moreover, referring to Table 3, Sample Nos. 53 through 64 have basically the same composition as that of Sample No. 18 of Example 1 shown in Table 1, except for the content of the aforementioned additional component. Measurement was made of the relative permittivity $\varepsilon r$, quality factor Qf value, resonant-frequency temperature coefficient $\tau f$ of each of Sample Nos. 53 through 64 thus produced in accordance with the same measurement method as that adopted in Example 1.

The result is shown in Table 2.

Table 3

| Sample No. | Na2O [mass%] | K2O [mass%] | CaO [mass%] | MgO [mass%] | SrO [mass%] | Fe2O3 [mass%] | SiO2 [mass%] | La2O3 [mass%] | CeO2 [mass%] | Pr6O11 [mass%] | ZrO2 [mass%] | Sum total [mass%] | Dielectric characteristics Relative permittivity εr | Dielectric characteristics Quality factor Qf | Dielectric characteristics Temperature coefficient τf in 25-85°C [ppm/°C] |
|---|---|---|---|---|---|---|---|---|---|---|---|---|---|---|---|
| 53 | - | - | - | - | - | 0.003 | - | - | - | - | 0.002 | 0.005 | 70 | 13200 | -4.3 |
| 54 | - | - | - | 0.001 | - | 0.004 | - | 0.001 | - | - | 0.002 | 0.008 | 70.1 | 13200 | -4.2 |
| 55 | 0.001 | - | - | 0.001 | - | - | 0.003 | 0.001 | 0.001 | - | 0.003 | 0.01 | 70.1 | 13300 | -4.3 |
| 56 | 0.008 | - | 0.003 | 0.006 | - | 0.007 | 0.012 | 0.008 | 0.007 | - | 0.009 | 0.06 | 70.0 | 13500 | -4.2 |
| 57 | 0.018 | - | 0.028 | 0.031 | 0.012 | 0.040 | 0.050 | 0.018 | 0.027 | 0.012 | 0.034 | 0.27 | 70.1 | 13600 | -4.1 |
| 58 | 0.020 | 0.001 | 0.048 | 0.052 | 0.015 | 0.050 | 0.090 | 0.027 | 0.039 | 0.014 | 0.044 | 0.40 | 70.2 | 13800 | -4.2 |
| 59 | 0.022 | 0.001 | 0.053 | 0.058 | 0.025 | 0.055 | 0.095 | 0.032 | 0.044 | 0.016 | 0.049 | 0.45 | 70.0 | 13400 | -4.2 |
| 60 | 0.025 | 0.002 | 0.068 | 0.078 | 0.047 | 0.095 | 0.105 | 0.045 | 0.059 | 0.027 | 0.069 | 0.62 | 69.9 | 13300 | -4.1 |
| 61 | 0.028 | 0.002 | 0.078 | 0.098 | 0.062 | 0.107 | 0.170 | 0.054 | 0.071 | 0.033 | 0.077 | 0.78 | 69.8 | 13200 | -4.8 |
| 62 | 0.030 | 0.003 | 0.088 | 0.118 | 0.077 | 0.170 | 0.194 | 0.063 | 0.081 | 0.039 | 0.087 | 0.95 | 69.7 | 13100 | -5.6 |
| 63 | 0.032 | 0.003 | 0.093 | 0.123 | 0.086 | 0.175 | 0.198 | 0.070 | 0.086 | 0.042 | 0.092 | 1.00 | 69.5 | 13000 | -5.2 |
| 64 | 0.032 | 0.004 | 0.096 | 0.123 | 0.089 | 0.180 | 0.202 | 0.070 | 0.086 | 0.042 | 0.096 | 1.02 | 69.3 | 12900 | -5.6 |

As shown in Table 3, it has been found that, in the case where the total content of the elements other than Ba, Nd, Ti and Al but excluding O in the dielectric ceramic is less than or equal to 1.0% by mass, as compared to the case with Sample No. 18 of Example 1, deterioration in dielectric characteristics can be suppressed more satisfactorily.

It has also been found that Sample Nos. 55 through 58 shown in Table 2 are, given that the content of the elements other than Ba, Nd, Ti and Al but excluding O falls in the range of 0.01% by mass or more and 0.4% by mass or less on oxide basis, higher in relative permittivity $\varepsilon r$ and in quality factor Qf value and smaller in resonant-frequency temperature coefficient $\tau f$ than Sample No. 18 of Example 1, as is more desirable.

Example 4

Next, tests to determine the influence of the void fraction of the $BaO$-$Nd_2O_3$-$TiO_2$-$Al_2O_3$-based material on the dielectric characteristics were carried out.

Samples for use in the tests were made basically in the same manner as that adopted in Example 1, except that their respective molded bodies were held while being fired for varying lengths of time, namely for 2 hours, 3 hours, 4 hours, 6 hours, 8 hours and 10 hours, respectively. Measurement was made of the relative permittivity $\varepsilon r$, quality factor Qf value, temperature coefficient $\tau f$ of each of Sample Nos. 65 through 70 thus produced in accordance with the same measurement method as that adopted in Example 1. Moreover, in determining the void fraction, photographs of given five areas of the surface of each sample were taken by SEM set at a proper magnification for observation of a range of 100 $\mu m$ x 100 $\mu m$, and these photographs were analyzed by an image analyzer (LUZEX-FS manufactured by Nireco Corporation) for calculation of void fractions, and the mean value of the calculated data was derived.

The result is shown in Table 3.

Table 4

| Sample No. | Void fraction | Dielectric characteristics | | |
|---|---|---|---|---|
| | [%] | Relative permittivity $\varepsilon r$ | Quality factor Qf | Temperature coefficient $\tau f$ in 25-85°C [ppm/°C] |
| 65 | 0.1 | 69.2 | 13200 | +14.8 |
| 66 | 0.8 | 69.0 | 13300 | +14.7 |
| 67 | 2.5 | 68.2 | 13200 | +14.6 |
| 68 | 3.8 | 67.9 | 13200 | +14.7 |
| 69 | 5.0 | 67.4 | 13100 | +14.6 |
| 70 | 5.1 | 67.3 | 12900 | +14.7 |

As shown in Table 3, in Sample Nos. 65 through 69 in which the void fraction is less than or equal to 5%, there was little decline in the relative permittivity $\varepsilon r$ and the quality factor Qf value, wherefore deterioration in dielectric characteristics could be suppressed with consequent stabilization of the dielectric characteristics, and the relative permittivity $\varepsilon r$ was increased with a decrease in the void fraction, which resulted in characteristics improvement.

Reference Signs List

| | |
|---|---|
| 1: | Dielectric filter |
| 2: | Metallic case |
| 3: | Input terminal |
| 4: | Output terminal |
| 5: | Ceramic body |
| 6: | Placement base |

**Claims**

**1.** A dielectric ceramic, comprising:

a main crystal phase containing Ba, Nd and Ti; and
a remainder,
part of Ti contained in the main crystal phase being substituted with Al, a content of the Al contained in the main crystal phase to a total content of Al in the main crystal phase and the remainder being greater than or equal to 10% on $Al_2O_3$ basis.

2. The dielectric ceramic according to claim 1,
wherein a constitution of the main crystal phase is expressed as: $aBaO \cdot bNd_2O_3 \cdot C (xTiO_2 + 1/2 \cdot (1-x)Al_2O_3)$, wherein values of a, b, c and x satisfy the following formulae (1) through (5):

$$13.50 \leq a \leq 16.10 \qquad (1)$$

$$17.60 \leq b \leq 19.40 \qquad (2)$$

$$65.30 \leq c \leq 67.80 \qquad (3)$$

$$0 < x < 1 \qquad (4)$$

$$a + b + c = 100 \qquad (5).$$

3. The dielectric ceramic according to claim 2,
wherein the value of x satisfies the following formula (6):

$$0.830 \leq x \leq 0.940 \qquad (6).$$

4. The dielectric ceramic according to claim 2 or 3,
wherein the values of a, b, c and x satisfy the following formula (7):

$$0.612 \leq cx/(a + b + cx) \leq 0.661 \qquad (7).$$

5. The dielectric ceramic according to any one of claims 1 to 4,
wherein the remainder contains Ba-Al-Ti-based oxide, $Al_2O_3$, $Nd_2O_3$, or a mixture thereof.

6. The dielectric ceramic according to claim 5,
wherein the Ba-Al-Ti-based oxide is $Ba_{1.23}Al_{2.46}Ti_{5.54}O_{16}$.

7. The dielectric ceramic according to claim 5 or 6,
wherein a proportion by volume of the remainder to a total of the main crystal phase and the remainder is less than or equal to 10% by volume but excludes 0.

8. The dielectric ceramic according to any one of claims 1 to 7,
wherein a total content of elements other than Ba, Nd, Ti and Al but excluding O in the main crystal phase and the remainder is less than or equal to 1.0% by mass on oxide basis.

9. A dielectric filter, comprising:

the dielectric ceramic according to any one of claims 1 to 8;
an input terminal electromagnetically coupled to the dielectric ceramic, to the input terminal an external electric signal being inputted; and
an output terminal electromagnetically coupled to the dielectric ceramic, the output terminal selectively outputting an electric signal corresponding to a resonant frequency of the dielectric ceramic.

*FIG. 1*

**EP 2 599 761 A1**

<table>
<tr><th colspan="2">INTERNATIONAL SEARCH REPORT</th><th>International application No.<br>PCT/JP2011/067492</th></tr>
</table>

**A. CLASSIFICATION OF SUBJECT MATTER**
*C04B35/468*(2006.01)i, *H01B3/12*(2006.01)i, *H01G4/12*(2006.01)i

According to International Patent Classification (IPC) or to both national classification and IPC

**B. FIELDS SEARCHED**

Minimum documentation searched (classification system followed by classification symbols)
C04B35/468, H01B3/12, H01G4/12

Documentation searched other than minimum documentation to the extent that such documents are included in the fields searched
Jitsuyo Shinan Koho          1922-1996   Jitsuyo Shinan Toroku Koho   1996-2011
Kokai Jitsuyo Shinan Koho    1971-2011   Toroku Jitsuyo Shinan Koho   1994-2011

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 1-227303 A (Toko, Inc.),<br>11 September 1989 (11.09.1989),<br>claims<br>(Family: none) | 1-9 |
| A | JP 63-117958 A (FDK Corp.),<br>21 May 1988 (21.05.1988),<br>claims<br>(Family: none) | 1-9 |
| A | YU Huichun et al., Dielectric properties and relaxor behavior of a new $(1-x)BaTiO_3-xBiAlO_3$ solid solution, JOURNAL OF APPLIED PHYSICS, Vol.103 No.3, 2008.02.01, P.034114-1~.34114-5, ABSTRACT | 1-9 |

☐ Further documents are listed in the continuation of Box C.          ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>10 August, 2011 (10.08.11) | Date of mailing of the international search report<br>23 August, 2011 (23.08.11) |
|---|---|
| Name and mailing address of the ISA/<br>Japanese Patent Office | Authorized officer |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1227303 A